# EUROPEAN PATENT SPECIFICATION

(11) **EP 2 797 118 B1**
(45) Date of publication and mention of the grant of the patent: **30.03.2022**
(21) Application number: 12859841.4
(22) Date of filing: 12.10.2012
(51) Int. Cl.: H01L 29/78, H01L 21/336, H01L 29/12, H01L 29/423

(54) **SEMICONDUCTOR DEVICE**
HALBLEITERBAUELEMENT
DISPOSITIF À SEMI-CONDUCTEURS

(30) Priority: 19.12.2011 JP 2011277046
(43) Date of publication of application: 29.10.2014
(73) Proprietor: Sumitomo Electric Industries, Ltd., Osaka-shi, Osaka 541-0041 (JP)
(72) Inventor: MASUDA, Takeyoshi, Osaka-shi, Osaka 554-0024 (JP)
(74) Representative: Grünecker Patent- und Rechtsanwälte PartG mbB
(86) International application number: PCT/JP2012/076488
(87) International publication number: WO 2013/094287

(56) References cited:
- EP-A1- 2 088 626
- WO-A1-2005/116307
- JP-A- 2005 012 051
- JP-A- 2005 340 685
- JP-A- 2007 165 657
- JP-A- 2007 258 465
- JP-A- 2007 281 195
- JP-A- 2008 135 653
- JP-A- 2009 302 510
- US-A1- 2007 015 333
- US-A1- 2007 057 262
- Yasuyuki Kawada ET AL: "Shape Control and Roughness Reduction of SiC Trenches by High-Temperature Annealing", Japanese Journal of Applied Physics, 20 November 2009 (2009-11-20), page 116508, XP055199212, DOI: 10.1143/JJAP.48.116508 Retrieved from the Internet: URL:http://iopscience.iop.org/1347-4065/48 /11R/116508/pdf/1347-4065_48_11R_116508.pd f [retrieved on 2015-06-30]
- S. TAKENAMI ET AL: "Sloped Sidewalls in 4H-SiC Mesa Structure Formed by a Cl<sub>2</sub>-O<sub>2</sub> Thermal Etching", MATERIALS SCIENCE FORUM, vol. 556-557, 15 September 2007 (2007-09-15), pages 733-736, XP055089875, DOI: 10.4028/www.scientific.net/MSF.556-557.733
- AGARWAL A K ET AL: "1.1 kV 4H-SiC power UMOSFETs", IEEE ELECTRON DEVICE LETTERS, IEEE SERVICE CENTER, NEW YORK, NY, US, vol. 18, no. 12, December 1997 (1997-12), pages 586-588, XP011424115, ISSN: 0741-3106, DOI: 10.1109/55.644079

## Description

### TECHNICAL FIELD

The present invention relates to a semiconductor device, and more particularly to a trench gate-type semiconductor device having a channel region formed in a region including a trench wall surface.

### BACKGROUND ART

In recent years, in order to achieve high breakdown voltage, low loss, and utilization of semiconductor devices under a high temperature environment, silicon carbide has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have high breakdown voltage, reduced ON resistance, and the like. Further, the semiconductor device thus adopting silicon carbide as its material has characteristics less deteriorated even under a high temperature environment than those of a semiconductor device adopting silicon as its material, advantageously.

In such a semiconductor device adopting silicon carbide as its material, it has been proposed to adopt a trench gate type which is advantageous for miniaturization of a unit cell and the like. Further, it has been proposed to improve switching characteristics in a trench gate-type semiconductor device by avoiding damage on a channel formation surface by ion implantation (see, for example, Japanese Patent Laying-Open No. 9-74191 (Patent Literature 1)).

### CITATION LIST

### PATENT LITERATURE

PTL 1: Japanese Patent Laying-Open No.9-74191

Patent Application Publication US 2007/0015333 A1 discloses a semiconductor device, comprising a substrate having a trench formed therein and made of silicon carbide, said trench being opened on one main surface side and having a side wall surface; a gate insulating film formed on said side wall surface in contact therewith; and a gate electrode formed on said gate insulating film in contact therewith, wherein said substrate includes a source region having a first conductivity type arranged to be exposed at said side wall surface, a body region having a second conductivity type which is arranged on a position opposite to said one main surface with respect to said source region, is in contact with said source region, and is exposed at said side wall surface, and wherein a side wall surface is flat at an atomic layer level. The trench may have side walls formed of the (03-38) plane of a 4H-SiC crystal.

### SUMMARY OF INVENTION

### TECHNICAL PROBLEM

However, even if damage on a channel formation surface by ion implantation is avoided as described in Patent Literature 1, the trench gate-type semiconductor device may have an increased channel resistance, and further reduction of an ON resistance may be required.

The present invention has been made to deal with such a problem, and one object of the present invention is to provide a semiconductor device capable of suppressing a channel resistance of a trench gate-type semiconductor device, and achieving further reduction of an ON resistance.

### SOLUTION TO PROBLEM

A semiconductor device in accordance with the present invention is defined in claim 1.

The inventor of the present invention studied the reason why the channel resistance of a trench gate-type semiconductor device cannot be sufficiently reduced even if damage on a channel formation surface by ion implantation is avoided. As a result, the inventor has found that the channel resistance can be reduced by decreasing a surface roughness of a side wall surface of a trench where a channel region is to be formed, than a conventional surface roughness. More specifically, the channel resistance can be effectively reduced by setting the surface roughness of the side wall surface to not more than 1.0 nm in RMS, in a microscopic range as calculated in a square region with each side of 100 nm.

In the semiconductor device in accordance with the present invention, the microscopic surface roughness of the side wall surface of the trench is reduced to not more than 1.0 nm in RMS. As a result, according to the semiconductor device in accordance with the present invention, a trench gate-type semiconductor device capable of suppressing a channel resistance and achieving further reduction of an ON resistance can be provided. The channel resistance can be further reduced by setting the microscopic surface roughness to not more than 0.4 nm in RMS. On the other hand, the microscopic surface roughness is not less than 0.07 nm due to atomic arrangement within a silicon carbide crystal. Such a microscopic surface roughness can be measured, for example, with an AFM (Atomic Force Microscope).

In the semiconductor device described above, the side wall surface may have a surface roughness lower than that of the main surface. Thus, the channel resistance can be suppressed more reliably by reducing the surface roughness of the side wall surface to be less than the surface roughness of the main surface.

In the semiconductor device described above, the trench may further have a bottom wall surface formed to intersect with the side wall surface, and the side wall surface may have a surface roughness lower than that of the bottom wall surface. Thus, the channel resistance can be suppressed more reliably by reducing the surface roughness of the side wall surface to be less than the surface roughness of the bottom wall surface of the trench.

In the semiconductor device described above, an angle formed by the side wall surface with respect to a {01-12} plane of the silicon carbide constituting the substrate may be smaller than an angle formed by the main surface with respect to a {0001} plane of the silicon carbide constituting the substrate.

The channel resistance can be reduced by approximating the side wall surface by the {01-12} plane. In addition, the channel resistance can be suppressed further reliably by decreasing the angle formed by the side wall surface with respect to the {01-12} plane to such an extent that the angle is smaller than the angle formed by the main surface with respect to the {0001} plane, that is, an off angle of the substrate main surface with respect to the {0001} plane.

In the semiconductor device described above, the angle formed by the main surface with respect to the {0001} plane of the silicon carbide constituting the substrate may be not more than 8°. Thereby, when a SiC substrate is obtained from an ingot of single crystal silicon carbide fabricated by growing silicon carbide in a <0001> direction which allows easy growth, the substrate can be obtained at a high yield and manufactured at a lower cost.

In the semiconductor device described above, the side wall surface may correspond to a specific crystal plane of the silicon carbide constituting the substrate. By constituting the side wall surface using a specific crystal plane, the microscopic surface roughness of the side wall surface can be easily reduced to not more than 1.0 nm in RMS.

In the semiconductor device claimed the side wall surface corresponds to a (0-11-2) plane including a (0-33-8) plane of the silicon carbide constituting the substrate.

The channel resistance is further reduced by constituting the side wall surface using a crystal plane made of a (0-11-2) plane. Since the (0-11-2) plane becomes chemically stable when it is microscopically formed as a (0-11-2) plane including a (0-33-8) plane, the (0-11-2) plane can be formed relatively easily. According to the invention, the (0-11-2) plane is formed relatively easily by being formed as a plane constituted by alternately providing the (0-33-8) plane and another plane which is connected to the (0-33-8) plane and is different from the (0-33-8) plane, for example, a (0-11-1) plane. Here, the term "microscopically" refers to "minutely to such an extent that at least the size about twice as large as an interatomic spacing is considered".

In the semiconductor device described above, the side wall surface may be formed by thermal etching. Thereby, the side wall surface is easily constituted using a specific crystal plane of the silicon carbide.

### ADVANTAGEOUS EFFECTS OF INVENTION

As is clear from the above description, according to the semiconductor device in accordance with the present invention, a semiconductor device capable of suppressing a channel resistance of a trench gate-type semiconductor device, and achieving further reduction of an ON resistance can be provided.

### BRIEF DESCRIPTION OF DRAWINGS

Fig. 1 is a schematic cross sectional view showing a structure of a MOSFET.
Fig. 2 is a flowchart schematically showing a method for manufacturing the MOSFET.
Fig. 3 is a schematic cross sectional view for illustrating the method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a schematic cross sectional view for illustrating the method for manufacturing the MOSFET.
Fig. 8 is a schematic cross sectional view for illustrating the method for manufacturing the MOSFET.
Fig. 9 is a schematic cross sectional view for illustrating the method for manufacturing the MOSFET.
Fig. 10 is a schematic cross sectional view for illustrating the method for manufacturing the MOSFET.
Fig. 11 is a schematic cross sectional view for illustrating the method for manufacturing the MOSFET.

### DESCRIPTION OF EMBODIMENTS

Hereinafter, an embodiment of the present invention will be described with reference to the drawings. It should be noted that in the below-mentioned drawings, the same or corresponding portions are given the same reference characters and are not described repeatedly. Further, in the present specification, an individual orientation is represented by [], a group orientation is represented by <>, an individual plane is represented by (), and a group plane is represented by {}. In addition, a negative index is supposed to be crystallographically indicated by putting "-" (bar) above a numeral, but is indicated by putting the negative sign before the numeral in the present specification. Furthermore, a Si (silicon) plane of hexagonal silicon carbide is defined as a (0001) plane, and a C (carbon) plane thereof is defined as a (000-1) plane. As a result, for example, of {01-12} planes, a plane on the Si plane side is expressed as a (01-12) plane, and a plane on the C plane side is expressed as a (0-11-2) plane. Here, the plane on the Si plane side refers to a plane having an angle of less than 90° with respect to the Si plane, and the plane on the C plane side refers to a plane having an angle of less than 90° with respect to the C plane.

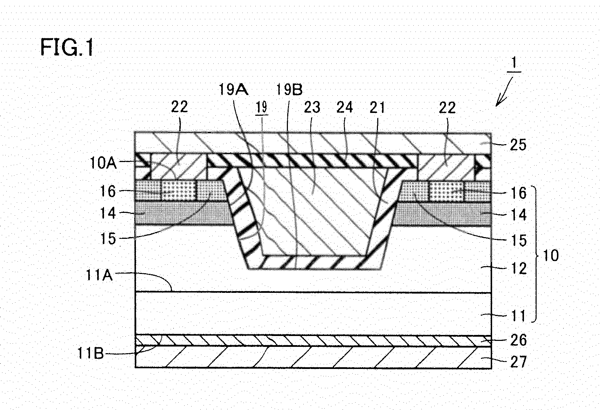

Firstly, as one embodiment of the present invention, a trench-type MOSFET (Metal Oxide Semiconductor Field Effect Transistor) as a semiconductor device, and a method for manufacturing the same will be described. Referring to Fig. 1, a MOSFET 1 includes a silicon carbide substrate 11 having n type conductivity (a first conductivity type), a drift layer 12 made of silicon carbide and having n type conductivity, a p type body region 14 having p type conductivity (a second conductivity type), an n⁺ region 15 having n type conductivity, and a p⁺ region 16 having p type conductivity. Silicon carbide substrate 11, drift layer 12, p type body region 14, n⁺ region 15, and p⁺ region 16 constitute a substrate 10.

Drift layer 12 is formed on one main surface 11A of silicon carbide substrate 11, and has n type conductivity because it contains an n type impurity. The n type impurity contained in drift layer 12 is, for example, N (nitrogen), and is contained at a concentration (density) lower than that of an n type impurity contained in silicon carbide substrate 11. Drift layer 12 is an epitaxial growth layer formed on one main surface 11A of silicon carbide substrate 11. Drift layer 12 may include a buffer layer having an increased impurity concentration in the vicinity of an interface with silicon carbide substrate 11.

In substrate 10, a trench 19 is formed which has tapered side wall surfaces 19A with a width therebetween gradually narrowed from a main surface 10A on a side opposite to a silicon carbide substrate 11 side toward the silicon carbide substrate 11 side, and a flat bottom wall surface 19B intersecting with side wall surfaces 19A and extending along main surface 10A. Each side wall surface 19A of trench 19 may be formed to have an angle of not less than 45° and not more than 90° with respect to a {0001} plane of silicon carbide constituting substrate 10.

P type body region 14 is formed to include the side wall of trench 19 (i.e., constitute a portion of the side wall of trench 19) within substrate 10, and to extend along main surface 11A in a direction away from the side wall of trench 19. P type body region 14 has p type conductivity because it contains a p type impurity. The p type impurity contained in p type body region 14 is, for example, Al (aluminum), B (boron), or the like.

N⁺ region 15 as a source region is formed to include the side wall of trench 19 within substrate 10, and to extend from p type body region 14 to main surface 10A. Specifically, n⁺ region 15 is formed to be in contact with p type body region 14, and to include the side wall of trench 19 and main surface 10A. N⁺ region 15 contains an n type impurity, for example, P (phosphorus) or the like, at a concentration (density) higher than that of the n type impurity contained in drift layer 12.

P⁺ region 16 is formed within substrate 10 to include main surface 10A and to be adjacent to (i.e., in contact with) n⁺ region 15. P⁺ region 16 contains a p type impurity, for example, Al or the like, at a concentration (density) higher than that of the p type impurity contained in p type body region 14. Trench 19 is formed to penetrate n⁺ region 15 and p type body region 14 and reach drift layer 12.

Specifically, substrate 10 includes n⁺ region 15 as a source region arranged to be exposed at side wall surface 19A of trench 19, and p type body region 14 which is arranged on a side of n⁺ region 15 opposite to main surface 10A, is in contact with n⁺ region 15, and is exposed at side wall surface 19A.

Further, referring to Fig. 1, MOSFET 1 includes a gate oxide film 21 serving as a gate insulating film, a gate electrode 23, a source contact electrode 22, an interlayer insulating film 24, a source wire 25, a drain electrode 26, and a backside surface protecting electrode 27.

Gate oxide film 21 is formed to cover a surface of trench 19 and to extend onto main surface 10A, and is made of, for example, silicon dioxide (SiO₂).

Gate electrode 23 is arranged in contact with gate oxide film 21 to fill trench 19. Gate electrode 23 is made of, for example, a conductor such as polysilicon doped with an impurity, Al, or the like.

Source contact electrode 22 is arranged in contact with n⁺ region 15 and p⁺ region 16 by extending from above n⁺ region 15 to above p⁺ region 16. Further, source contact electrode 22 is made of a material that can make ohmic contact with n⁺ region 15 and p⁺ region 16, for example, NiₓSi_{y} (nickel silicide), TiₓSi_{y} (titanium silicide), AlₓSi_{y} (aluminum silicide), TiₓAl_{y}Si_{z} (titanium aluminum silicide), or the like.

Interlayer insulating film 24 is formed above main surface 10A of substrate 10 to surround gate electrode 23 together with gate oxide film 21 and to separate gate electrode 23 from source contact electrode 22 and source wire 25, and is made of, for example, silicon dioxide (SiO₂) serving as an insulator.

Source wire 25 is formed above main surface 10A of substrate 10 to cover surfaces of interlayer insulating film 24 and source contact electrode 22. Further, source wire 25 is made of a conductor such as Al, and is electrically connected with n⁺ region 15 via source contact electrode 22.

Drain electrode 26 is formed in contact with a main surface 11B of silicon carbide substrate 11 on a side opposite to a side on which drift layer 12 is formed. Drain electrode 26 is made of a material that can make ohmic contact with silicon carbide substrate 11, for example, the same material as that for source contact electrode 22, and is electrically connected with silicon carbide substrate 11.

Backside surface protecting electrode 27 is formed to cover drain electrode 26, and is made of, for example, Al or the like serving as a conductor.

Next, an operation of MOSFET 1 will be described. Referring to Fig. 1, in a state where gate electrode 23 has a voltage less than a threshold voltage, that is, in an OFF state, even if a voltage is applied between drain electrode 26 and source contact electrode 22, pn junction between p type body region 14 and drift layer 12 is reverse-biased, and thus a non-conductive state is obtained. On the other hand, when a voltage equal to or higher than the threshold voltage is applied to gate electrode 23, an inversion layer is formed in a channel region in the vicinity of a portion of p type body region 14 in contact with gate oxide film 21. As a result, n⁺ region 15 and drift layer 12 are electrically connected to each other and an ON state is achieved, and a current flows between source contact electrode 22 and drain electrode 26.

Here, in MOSFET 1 in accordance with the invention a square region with each side of 100 nm in side wall surface 19A of trench 19 has a surface roughness of not more than 1.0 nm in RMS. Thereby, a surface of p type body region 14 in contact with gate oxide film 21 is smoothed, suppressing a channel resistance. As a result, MOSFET 1 in accordance with the present embodiment serves as a trench gate-type semiconductor device capable of achieving reduction of an ON resistance. It should be noted that the channel resistance can be suppressed more reliably by setting the surface roughness of side wall surface 19A to not more than 0.4 nm in RMS.

Preferably, in MOSFET 1, side wall surface 19A has a surface roughness (RMS) lower than that of main surface 10A. Thereby, the channel resistance can be suppressed more reliably.

Preferably, in MOSFET 1, side wall surface 19A has a surface roughness (RMS) lower than that of the bottom wall surface. Thereby, the channel resistance can be suppressed further reliably.

Preferably, in MOSFET 1, an angle formed by side wall surface 19A with respect to a {01-12} plane of the silicon carbide constituting substrate 10 is smaller than an angle formed by main surface 10A with respect to the {0001} plane of the silicon carbide constituting substrate 10. Thereby, the channel resistance can be reduced further reliably.

Preferably, in MOSFET 1, the angle formed by main surface 10A with respect to the {0001} plane of the silicon carbide constituting substrate 10 is not more than 8°. Thereby, when silicon carbide substrate 11 is obtained from an ingot of single crystal silicon carbide fabricated by growing silicon carbide in a <0001> direction which allows easy growth, silicon carbide substrate 11 can be obtained at a high yield and manufactured at a lower cost.

Further, in MOSFET 1, side wall surface 19A corresponds to the claimed specific crystal plane of the silicon carbide constituting substrate 10. By constituting side wall surface 19A using the specific crystal plane, the surface roughness of side wall surface 19A can be easily reduced.

Furthermore, in MOSFET 1, side wall surface 19A corresponds to a (0-11-2) plane including a (0-33-8) plane of the silicon carbide constituting substrate 10. Thereby, the channel resistance can be further reduced.

In addition, in MOSFET 1, side wall surface 19A may be formed by thermal etching. Thereby, side wall surface 19A is easily constituted using a specific crystal plane of the silicon carbide.

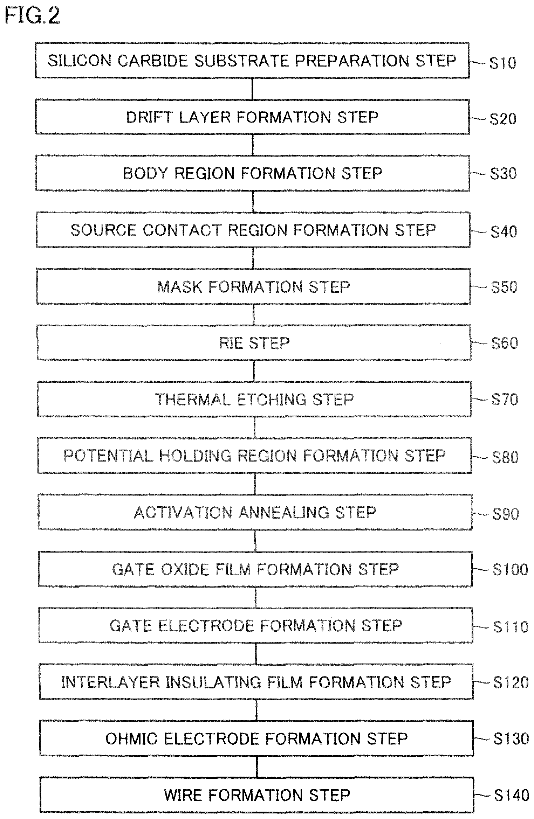

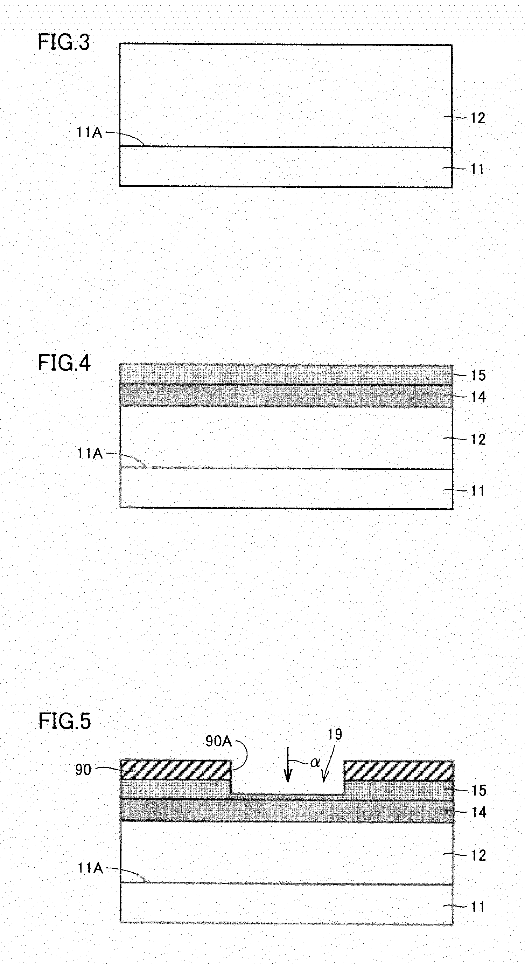

Next, one example of a method for manufacturing MOSFET 1 in the present embodiment will be described with reference to Figs. 2 to 11. Referring to Fig. 2, in the method for manufacturing MOSFET 1 in the present embodiment, firstly, a silicon carbide substrate preparation step is performed as a step (S10). In this step (S10), referring to Fig. 3, silicon carbide substrate 11 made of, for example, 4H hexagonal silicon carbide is prepared.

Next, a drift layer formation step is performed as a step (S20). In this step (S20), referring to Fig. 3, drift layer 12 made of silicon carbide is formed on one main surface 11A of silicon carbide substrate 11 by epitaxial growth.

Next, a body region formation step is performed as a step (S30). In this step (S30), referring to Figs. 3 and 4, p type body region 14 is formed by implanting, for example, Al ions into drift layer 12. On this occasion, p type body region 14 is formed to have a thickness equal to the combined thickness of p type body region 14 and n⁺ region 15 in Fig. 4.

Next, a source contact region formation step is performed as a step (S40). In this step (S40), referring to Fig. 4, n⁺ region 15 is formed by implanting, for example, P ions into p type body region 14 formed in step (S30). As a result, a structure shown in Fig. 4 is obtained.

Next, a mask formation step is performed as a step (S50). In this step (S50), referring to Fig. 5, a mask layer 90 is formed which has an opening 90A, for example, at a desired region in which trench 19 is to be formed, and is made of silicon dioxide.

Next, an RIE step is performed as a step (S60). In this step (S60), RIE (Reactive Ion Etching) is performed using mask layer 90 formed in step (S50) as a mask. Thereby, etching proceeds linearly along an arrow α, forming trench 19 having a planar shape substantially identical to that of opening 90A. Although trench 19 is formed to remove a portion of n⁺ region 15 in Fig. 5. trench 19 may be formed to penetrate n⁺ region 15 and reach p type body region 14.

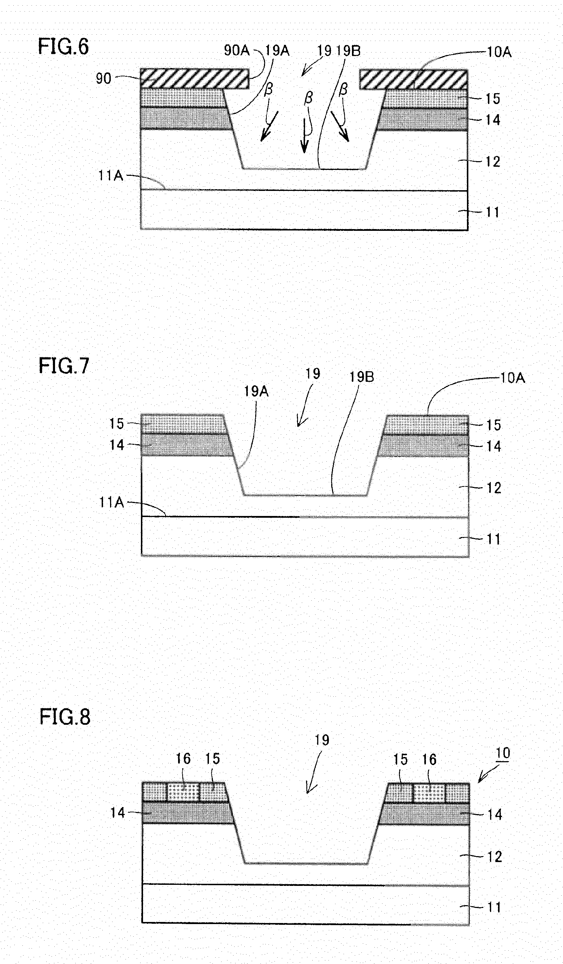

Next, a thermal etching step is performed as a step (S70). In this step, referring to Figs. 5 and 6, thermal etching using, for example, a halogen-based gas is performed. Thereby, the trench formed in step (S60) is enlarged along arrows β. As a result, trench 19 is formed which penetrates n⁺ region 15 and p type body region 14 and extends in a direction along main surface 11A of silicon carbide substrate 11 (in Fig. 5, in a depth direction of the paper plane).

On this occasion, referring to Fig. 6, for example, main surface 10A of substrate 10 can have an off angle of not more than 8° with respect to a (000-1) plane. Thereby, side wall surface 19A of trench 19 can correspond to a chemically stable crystal plane, according to the claimed invention, the (0-11-2) plane including the (0-33-8) plane. As a result, the surface roughness of side wall surface 19A can be significantly reduced, and the channel resistance can be reduced. Thereafter, mask layer 90 is removed as shown in Fig. 7, and thereby trench 19 is completed. Through such a procedure, the microscopic surface roughness of side wall surface 19A of trench 19 can be reduced to not more than 1.0 nm in RMS, and the surface roughness of side wall surface 19A can be reduced to be lower than the surface roughnesses of main surface 10A and bottom wall surface 19B.

Next, a potential holding region formation step is performed as a step (S80). In this step (S80), referring to Figs. 7 and 8, p⁺ region 16 is formed by implanting, for example, Al ions into n⁺ region 15 formed in step (S40). The ion implantation for forming p⁺ region 16 can be performed, for example, by forming a mask layer made of silicon dioxide (SiO₂) and having an opening at a desired region into which ions are to be implanted, over a surface of n⁺ region 15. Thereby, substrate 10 constituting MOSFET 1 is completed.

Next, an activation annealing step is performed as a step (S90). In this step (S90), the impurities introduced in steps (S30), (S40), and (S80) are activated by heating substrate 10. Specifically, substrate 10 is heated, for example, to a temperature range of not less than 1600°C and not more than 1900°C, and held for a time period of not less than one minute and not more than 30 minutes. Thereby, desired carriers are generated in the regions having the impurities introduced therein.

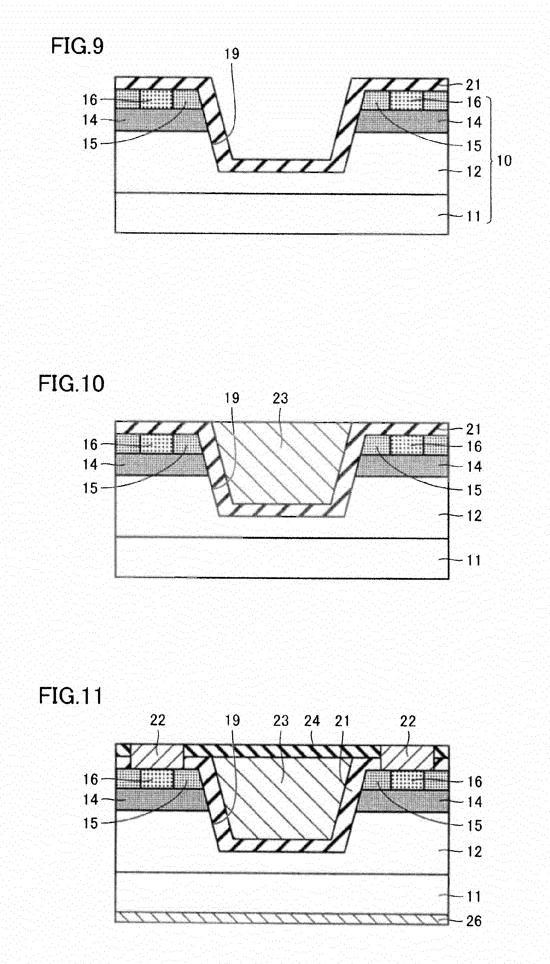

Next, a gate oxide film formation step is performed as a step (S100). In this step (S100), referring to Fig. 9, gate oxide film 21 is formed, for example, by performing heat treatment of heating the substrate to 1300°C in an oxygen atmosphere and holding it for 60 minutes.

Next, a gate electrode formation step is performed as a step (S110). In this step (S110), referring to Fig. 10, a polysilicon film filling trench 19 is formed, for example, by a LPCVD (Low Pressure Chemical Vapor Deposition) method. Thereby, gate electrode 23 is formed.

Next, an interlayer insulating film formation step is performed as a step (S120). In this step (S120), referring to Figs. 10 and 11, interlayer insulating film 24 made of SiO₂ serving as an insulator is formed, for example, by a P (Plasma)-CVD method, to cover gate electrode 23 and gate oxide film 21.

Next, an ohmic electrode formation step is performed as a step (S130). In this step (S130), referring to Fig. 11, a hole portion penetrating interlayer insulating film 24 and gate oxide film 21 is formed at a desired region in which source contact electrode 22 is to be formed. Then, for example, a film made of Ni is formed to fill the hole portion. On the other hand, a film to serve as drain electrode 26, for example, a film made of Ni, is formed to be in contact with the main surface of silicon carbide substrate 11 on the side opposite to the drift layer 12 side. Thereafter, alloy heating treatment is performed to silicidize at least a portion of the films made of Ni, and thereby source contact electrode 22 and drain electrode 26 are completed.

Next, a wire formation step is performed as a step (S140). In this step (S140), referring to Figs. 11 and 1, for example, source wire 25 made of Al serving as a conductor is formed above main surface 10A by an evaporation method to cover upper surfaces of interlayer insulating film 24 and source contact electrode 22. Further. backside surface protecting electrode 27 also made of Al is formed to cover drain electrode 26. Through the above procedure, manufacturing of MOSFET 1 as the semiconductor device in the present embodiment is completed.

Although the above embodiment has described a trench-type MOSFET as one example of the semiconductor device in the present embodiment, the semiconductor device in the present invention is not limited thereto, and is widely applicable to a semiconductor device having a trench gate such as a trench-type IGBT (Insulated Gate Bipolar Transistor).

It should be understood that the embodiment disclosed herein is illustrative and non-restrictive in every respect. The scope of the present invention is defined by the scope of the claims, rather than the description above.

### INDUSTRIAL APPLICABILITY

The semiconductor device in accordance with the present invention is particularly advantageously applicable to a semiconductor device having a trench gate.

### REFERENCE SIGNS LIST

1: MOSFET; 10: substrate; 10A: main surface; 11: silicon carbide substrate; 11A, 11B: main surface; 12: drift layer; 14: p type body region; 15: n⁺ region; 16: p⁺ region; 19: trench; 19A: side wall surface; 19B: bottom wall surface; 21: gate oxide film; 22: source contact electrode; 23: gate electrode; 24: interlayer insulating film; 25: source wire; 26: drain electrode; 27: backside surface protecting electrode; 90: mask layer; 90A: opening.

## Claims

1. A semiconductor device, comprising:
a substrate (10) having a trench (19) formed therein and made of silicon carbide, said trench (19) being opened on one main surface (10A) side and having a side wall surface (19A);
a gate insulating film (21) formed on said side wall surface (19A) in contact therewith; and
a gate electrode (23) formed on said gate insulating film (21) in contact therewith,
wherein said substrate (10) includes
a source region (15) having a first conductivity type arranged to be exposed at said side wall surface,
a body region (14) having a second conductivity type which is arranged on a position opposite to said one main surface with respect to said source region, is in contact with said source region, and is exposed at said side wall surface, and wherein
a square region with each side of 100 nm in said side wall surface of said trench where a channel region is to be formed has a surface roughness of not more than 1.0 nm in RMS,
and said side wall surface consists of a (0-11-2) plane microscopically constituted by alternately providing a (0-33-8) plane and another plane which is connected to said (0-33-8) plane and is different from said (0-33-8) plane.

2. The semiconductor device according to claim 1, wherein said side wall surface has a surface roughness lower than that of said main surface.

3. The semiconductor device according to claim 1 or 2, wherein
said trench further has a bottom wall surface formed to intersect with said side wall surface, and
said side wall surface has a surface roughness lower than that of said bottom wall surface.

4. The semiconductor device according to any of claims 1 to 3, wherein an angle formed by said side wall surface with respect to a {01-12} plane of the silicon carbide constituting said substrate is smaller than an angle formed by said main surface with respect to a {0001} plane of the silicon carbide constituting said substrate.

5. The semiconductor device according to any of claims 1 to 4, wherein an angle formed by said main surface with respect to a {0001} plane of the silicon carbide constituting said substrate is not more than 8°.

## Patentansprüche

1. Halbleiterbauelement, umfassend:
ein Substrat (10) mit einem darin ausgebildeten Graben (19) aus Siliziumkarbid, wobei der Graben (19) auf einer Seite der Hauptfläche (10A) offen ist und eine Seitenwandfläche (19A) aufweist;
einen Gate-Isolierfilm (21), der auf der Seitenwandfläche (19A) in Kontakt mit dieser ausgebildet ist; und
eine Gate-Elektrode (23), die auf dem Gate-Isolierfilm (21) in Kontakt mit diesem ausgebildet ist,
wobei das Substrat (10) Folgendes umfasst
ein Source-Gebiet (15) mit einem ersten Leitfähigkeitstyp, das so angeordnet ist, dass es an der Seitenwandfläche freiliegt,
ein Körpergebiet (14) mit einem zweiten Leitfähigkeitstyp, das an einer Position gegenüber der einen Hauptfläche in Bezug auf das Source-Gebiet angeordnet ist, in Kontakt mit dem Source-Gebiet steht und an der Seitenwandfläche freiliegt, und
wobei ein quadratischer Bereich mit jeder Seitenlänge von 100 nm in der Seitenwandfläche des Grabens, in dem ein Kanalbereich gebildet werden soll, eine Oberflächenrauhigkeit von nicht mehr als 1,0 nm in RMS aufweist, und die Seitenwandfläche aus einer (0-11-2)-Ebene besteht,
die mikroskopisch durch abwechselndes Bereitstellen einer (0-33-8)-Ebene und einer anderen Ebene, die mit der (0-33-8)-Ebene verbunden ist und sich von der (0-33-8)-Ebene unterscheidet,
gebildet wird.

2. Halbleiterbauelement nach Anspruch 1, wobei die Seitenwandfläche eine geringere Oberflächenrauhigkeit als die Hauptfläche aufweist.

3. Halbleiterbauelement nach Anspruch 1 oder 2, wobei
der Graben ferner eine Bodenwandfläche aufweist, die so ausgebildet ist, dass sie sich mit der Seitenwandfläche schneidet, und
die Seitenwandfläche eine geringere Oberflächenrauhigkeit als die Bodenwandfläche aufweist.

4. Halbleiterbauelement nach einem der Ansprüche 1 bis 3, wobei ein von der Seitenwandfläche gebildeter Winkel in Bezug auf eine {01-12}-Ebene des das Substrat bildenden Siliziumkarbids kleiner ist als ein von der Hauptfläche gebildeter Winkel in Bezug auf eine {0001}-Ebene des das Substrat bildenden Siliziumkarbids.

5. Halbleiterbauelement nach einem der Ansprüche 1 bis 4, wobei ein von der Hauptfläche gebildeter Winkel in Bezug auf eine {0001}-Ebene des das Substrat bildenden Siliziumkarbids nicht mehr als 8° beträgt.

## Revendications

1. Composant à semi-conducteur comprenant :
un substrat (10) comportant une tranchée (19) formée sur lui et constituée de carbure de silicium, ladite tranchée (19) étant ouverte sur une première surface principale (10A) et comportant une surface de paroi latérale (19A),
un film d'isolation de grille (21) formé sur ladite surface de paroi latérale (19A) en contact avec celle-ci, et
une électrode de grille (23) formée sur ledit film d'isolation de grille (21) en contact avec celui-ci,
ledit substrat (10) incluant :
une zone de source (15), présentant un premier type de conductivité, disposée pour être exposée au niveau de ladite surface de paroi latérale,
une zone de corps (14), présentant un second type de conductivité, laquelle est agencée sur une position opposée à ladite première surface principale par rapport à ladite zone de source, se trouve en contact avec ladite zone de source et est exposée au niveau de ladite surface de paroi latérale, et
dans lequel
une zone carrée, dont chaque côté fait 100 nm dans ladite surface de paroi latérale de ladite tranchée où doit être formée une zone de canal, présente une rugosité de surface qui n'est pas supérieure à 1,0 nm en valeur quadratique moyenne, et ladite surface de paroi latérale est constituée d'un plan (0-11-2) constitué de façon microscopique en utilisant en alternance un plan (0-33-8) et un autre plan qui est relié au dit plan (0-33-8) et qui est différent dudit plan (0-33-8).

2. Composant à semi-conducteur selon la revendication 1, dans lequel ladite surface de paroi latérale présente une rugosité de surface inférieure à celle de ladite surface principale.

3. Composant à semi-conducteur selon la revendication 1 ou la revendication 2, dans lequel :
ladite tranchée comporte en outre une surface de paroi de fond formée pour se croiser avec ladite surface de paroi latérale, et
ladite surface de paroi latérale présente une rugosité de surface inférieure à celle de ladite surface de paroi de fond.

4. Composant à semi-conducteur selon l'une quelconque des revendications 1 à 3, dans lequel l'angle formé par ladite surface de paroi latérale par rapport à un plan {01-12} du carbure de silicium constituant ledit substrat est inférieur à l'angle formé par ladite surface principale par rapport à un plan {0001} du carbure de silicium constituant ledit substrat.

5. Composant à semi-conducteur selon l'une quelconque des revendications 1 à 4, dans lequel l'angle formé par ladite surface principale par rapport à un plan {0001} du carbure de silicium constituant ledit substrat n'est pas supérieur à 8 °.
